Europäisches Patentamt

European Patent Office

Office européen des brevets

(19)

Publication number: **0 276 914**
**A2**

## EUROPEAN PATENT APPLICATION

(21) Application number: **88300157.0**

(22) Date of filing: **11.01.88**

(51) Int. Cl.4: **C30B 23/02**

(30) Priority: **28.01.87 US 7748**

(43) Date of publication of application:
**03.08.88 Bulletin 88/31**

(84) Designated Contracting States:
**DE ES FR GB IT NL**

(71) Applicant: **AMERICAN TELEPHONE AND TELEGRAPH COMPANY**
**550 Madison Avenue**
**New York, NY 10022(US)**

(72) Inventor: **Xie, Ya-Hong**
**135 Whiton Road**
**Neshanic Station New Jersey 0885(US)**

(74) Representative: **Johnston, Kenneth Graham et al**
**AT&T (UK) LTD. AT&T Intellectual Property Division 5 Mornington Road**
**Woodford Green Essex, IG8 OTU(GB)**

(54) **Anti-flaking measures in molecular-beam-epitaxy apparatus, and method of manufacture.**

(57) Molecular beam epitaxy deposition apparatus is designed for minimized flake-off material deposited on interior surfaces, thereby reducing evaporation source material contamination. minimizing the presence of extraneous particles on deposition surfaces. and enhancing the production yield of semiconductor device chips. Such design includes a surface whose properties match those of material being deposited, also. surface heating can be employed. Particularly effective are provisions for epitaxial deposition on surfaces. These measures may be applied, e.g., to shutters and to cover plates, and especially in apparatus for the deposition of silicon and germanium by electron-beam evaporation.

EP 0 276 914 A2

Xerox Copy Centre

# ANTI-FLAKING MEASURES IN MOLECULAR-BEAM-EPITAXY APPARATUS AND METHOD OF MANUFACTURE

## Technical Field

The invention is concerned with molecular-beam-epitaxy deposition apparatus and with the use of such apparatus.

## Background of the Invention

Molecular-beam epitaxy (MBE) as compared, e.g., with chemical vapor deposition (CVD) offers a number of advantages in device manufacture such as, e.g., high-precision control over dopant levels and of deposited layer thickness. While many well-established semiconductor devices can be manufactured satisfactorily without such control, MBE capabilities have particularly benefited more recent device developments as based on the use of precisely defined heterostructures and, especially, heterostructure superlattices. In this respect, MBE deposition is no longer considered to be of interest primarily in the manufacture of semiconductor devices based on Group III-V and Group II-VI compound semiconductor materials; rather, superlattice devices may typically involve the deposition of precisely controlled layers of silicon, germanium, silicon-germanium alloys, and compounds involving silicon or germanium.

Initially, MBE apparatus specifically intended for silicon and germanium epitaxial layer deposition was designed largely to satisfy research needs, and of paramount importance in that respect are analytical instrumentation, variety of evaporation and ionization sources, and pumping facilities for producing ultra-high vacuum conditions. However, as devices are being developed for commercial production, other aspects are receiving attention such as, e.g., ease of loading and unloading, capability to handle large-diameter substrates, and yield in the production of semiconductor chips. In this respect, see, e.g.,

J. C. Beam et al., "Silicon MBE Apparatus for Uniform High-rate Deposition on Standard Format Wafers", *Journal of Vacuum Science and Technology,* Vol. 20 (1982), pp. 137-142.

Silicon-MBE deposition apparatus typically includes evaporation sources from which molecular (atomic) beams of silicon and germanium are produced by electron-beam evaporation, and the molecular beams are directed upwards for deposition on a substrate. Typically also, mechanical shutters are provided over evaporation sources for the sake of precise timing of deposition.

It has been observed that, due to so-called flake-off of particles deposited at various interior surfaces of MBE deposition apparatus, upward-facing evaporation source-material may become contaminated, resulting in quality impairment of deposited layers. Quality impairment may be further due to particles becoming attached directly to the substrate, resulting in low production yields.

For a general treatment of the physics of particles on surfaces see, e.g.,
R. A. Bowling, "An Analysis of Particle Adhesion on Semiconductor Surfaces", *Journal of the Electrochemical Society: Solid-State Science and Technology,* Vol. 132 (1985), pp. 2208-2214.

Cited further, with respect to silicon and germanium oxidation thermodynamics, are the papers by
O. Kubaschewski et al., "Silicon Monoxide Pressures Due to the Reaction between Solid Silicon and Silica", *Journal of Chemical Thermodynamics,* Vol. 6 (1974), pp. 467-476, and
W. L. Jolly et al., "The Equilibrium Ge(s) + GeO$_2$(s) = 2GeO(g). The Heat of Formation of Germanic Oxide", *Journal of the American Chemical Society,* Vol. 74 (1952), pp. 5757-5758.

## Summary of the Invention

In the interest of reduced source material contamination and reduced extraneous-particle counts on substrates, molecular beam epitaxy deposition apparatus is equipped with means for reducing flake-off of material from interior surfaces of deposition apparatus; such means provide for enhanced adherence of evaporated materials on surfaces. Suitable in this respect are surface materials having thermal properties which match those of material being evaporated; suitable further is surface heating so as to desorb possible surface oxides before initiation of MBE growth and to maintain, during the growth process, surface temperature required for epitaxial growth. Particularly favorable conditions are realized when material being evaporated is deposited epitaxially on an apparatus surface.

## Brief Description of the Drawings

FIG. 1 is a schematic view of a specific embodiment of a portion of molecular-beam-epitaxy apparatus designed for minimized flake-off in accordance with the invention; and

FIG. 2 is a schematic, reduced-scale, cross-sectional view of typical MBE apparatus including evaporation sources, designed for minimized flake-off in accordance with the invention.

Detailed Description

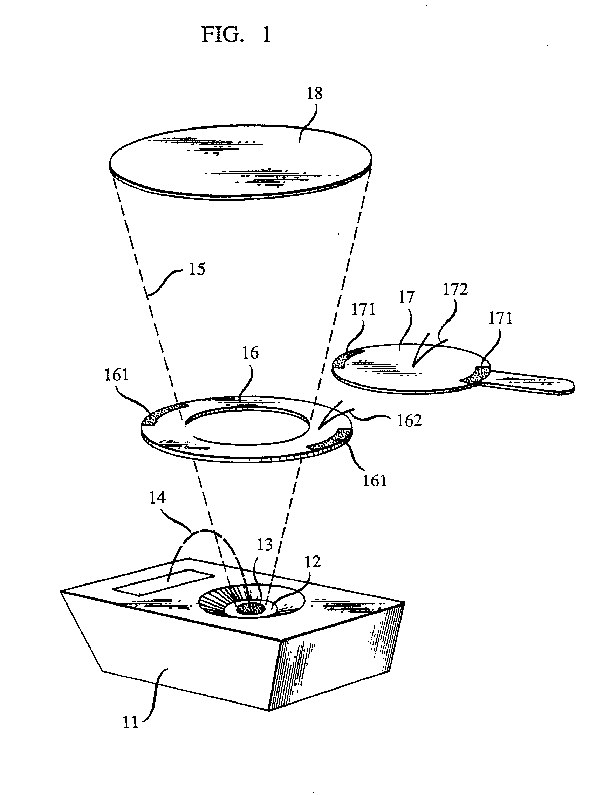

FIG. 1 shows electron-beam evaporation source 11, evaporation source material 12 with molten portion or pool 13, electron beam 14, molecular beam 15, cover plate 16 with electrical contacts 161 and thermocouple 162, and shutter 17 with electrical contacts 171 and thermocouple 172. Preferably, the size of the aperture of the cover plate is just large enough for the molecular beam of the source material to be incident on substrate 18 only, without spreading to other parts of deposition apparatus.

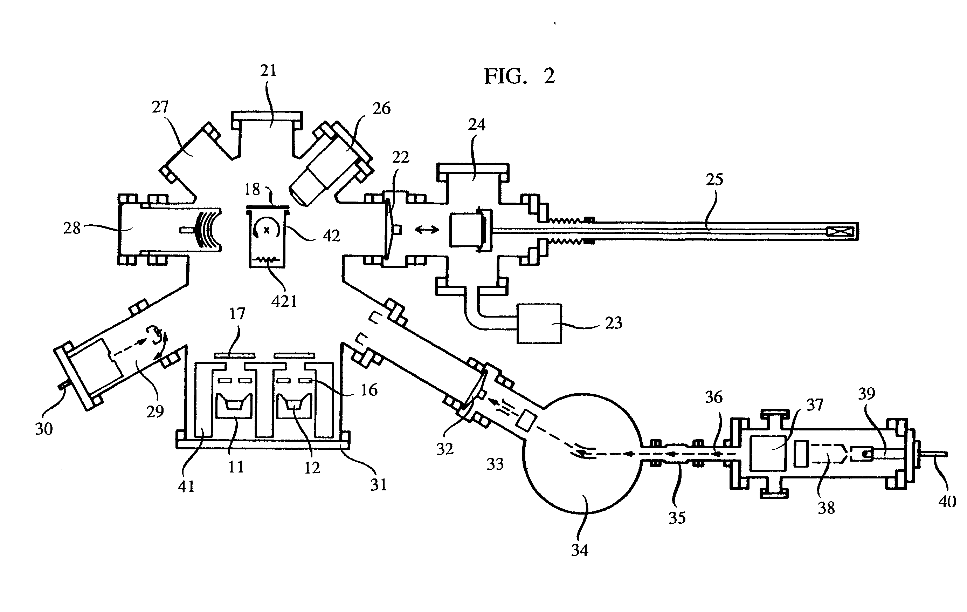

FIG. 2 shows vacuum chamber 21 with valve 22, vacuum pump 23, and loading port 24 with magnetically coupled insertion apparatus 25. Further provided are Auger electron spectroscopy device 26, viewport 27, rear-view low-energy electron diffraction device 28, sputter-cleaning gun 29, gas inlet 30, source flange 31, valve 32, raster-scan plates 33, neutral-beam trap 34, valve 35, deceleration and refocus device 36, Wien mass filter 37, extraction and focusing device 38, ion source 39, gas inlet 40, and cryopanels 41. Sample holder 42 is equipped with a heater 421 and can be rotated to face evaporation sources or inspection facilities. Further shown, in correspondence with FIG. 1, are two electron-beam evaporation sources 11 with source material 12, cover plates 16, shutter 17, and substrate 18. Though not depicted, MBE-deposition apparatus may further inlcude additional facilities and devices such as, e.g., a high-energy electron diffraction device and a deposition meter.

The apparatus depicted in FIG. 2 is similar to apparatus described in the paper by J. C. Bean et al. cited above, whose operation involves a number of well-known steps including out-gassing, loading, evaporation and deposition, and sensing and automatic control. Apparatus in accordance with the invention is distinguished over prior art apparatus in that, in the interest of minimized presence of particles, at least a portion of an interior surface in MBE apparatus is provided with means for enhancing adherence of evaporated material. As a result of enhanced adherence, flake-off and attendant contamination of source material are minimized. The invention is particularly applicable to horizontal, downward-facing surfaces such as low surfaces of cover plate 16 and shutter 17, and any other surfaces that may be facing material being evaporated at some time during or after deposition operation. However, the invention also applies to surfaces whose position is other than horizontal, including surfaces facing upward.

Among means for maximized adherence of material deposited on an MBE apparatus interior surface, in accordance with the invention, are choice of surface material to match the composition of the material being evaporated; for example, evaporation sources for silicon, germanium, cobalt, or nickel may be equipped with cover plates 16 and shutters 17 made of the same respective material. More generally, surface material may be chosen having thermal expansion properties matching those of the material being evaporated.

Furthermore, cover plate 16, shutter 17, and other surfaces may preferably be equipped with heating means and also with temperature sensors, thereby permitting temperature control, e.g., via feedback from temperature sensors to a heating current control. Maximized adherence of evaporated material on surfaces can be realized if deposition on such surfaces is epitaxial; this, too, is facilitated by temperature control of suitable surface materials having suitably matching lattice parameters.

The invention is applicable wherever there is a possibility of material which had been deposited on an interior surface of deposition apparatus to become dislodged and then fall or be transported into an evaporation source or onto a substrate deposition surface. The invention is of particular importance for vertical or near-vertical evaporation sources such as, e.g., electron-beam evaporation sources for silicon, germanium, cobalt, and nickel. MBE apparatus in accordance with the invention includes one or several evaporation sources as may be used to deposit elemental materials, alloys, and compounds such as, e.g., $CoSi_2$ and $NiSi_2$. While deposition of compound and alloy layers typically involves the use of two or more elemental sources, evaporation of compound and alloyed source materials is not precluded.

Among advantages realized in apparatus in accordance with the invention, and realized by processing in accordance with the invention, are minimized evaporation source contamination as well as minimized inclusion of extraneous particles on a substrate deposition surface. As a result of attendant high quality of deposited layers, enhanced production yield is realized in device chips made from wafers processed in accordance with the invention.

The following Examples serve to illustrate the invention in the cases of silcion-MBE and of germanium-MBE deposition. All numerical values are understood to be approximate.

Example 1.

A silicon evaportion source is equipped with a silicon cover plate 16 and a silicon shutter 17, equipped with electrical contacts 161 and 171 for ohmic heating. Before the electron-beam evaporation source is turned on, the cover plate 16 and shutter 17 are heated at a temperature of 950 degrees C for 5 minutes. This procedure serves to evaporate the native oxide layer from the shutter and cover plate prior to deposition; in this respect see the paper by O. Kubaschewski et al. cited above. The temperature is then lowered to 650 degrees C, and the evaportion source is turned on. During the growth process the shutter and cover plate temperatures are maintained at 650 degrees C; lowering of temperature to room temperature occurs only after the electron-beam evaporation source has been turned off.

Example 2.

A germanium evaporation source is equipped with a germanium cover plate 16 and a germanium shutter 17, equipped with electrical contacts 161 and 171 for ohmic heating. Before the electron-beam evaporation source is turned on, the cover plate 16 and shutter 17 are heated at a temperature of 600 degrees C for 5 minutes to evaporate the native oxide layer from the shutter and cover plate prior to deposition; see the paper by W. L. Jolly et al. cited above. The temperature is then lowered to 550 degrees C, and the evaporation source is turned on. During the growth process the shutter and cover plate temperature are maintained at 550 degrees C.

**Claims**

1. Deposition apparatus, said apparatus comprising a vacuum chamber, evaporation means disposed in said vacuum chamber, and means disposed in said vacuum chamber for exposing a substrate to a beam of atoms or molecules originating from said evaporation means, said apparatus being CHARACTERISED IN THAT at least a portion of a surface of said apparatus interior to said vacuum chamber comprises adherence means for a material to originate from said evaporation means, the material of said adherence means being chosen to permit epitaxial-deposition of said atoms or molecules on said adherence means.

2. The apparatus of claim 1, said adherence means CHARACTERISED BY heating means.

3. The apparatus of claim 1, said adherence means CHARACTERISED BY temperature monitoring means.

4. The apparatus of claim 1, CHARACTERISED IN THAT the adherence means is present on an evaporation means cover plate.

5. The apparatus of claim 4, CHARACTERISED IN THAT said adherence means comprises heating means and in that said heating means comprises electrical contacts on said cover plate.

6. The apparatus of claim 1, CHARACTERISED IN THAT said adherence means is present on a shutter.

7. The apparatus of claim 6, CHARACTERSED IN THAT said adherence means comprises heating means, and in that said heating means comprises electrical contacts on said shutter.

8. A method for making a device, said method comprising depositing an epitaxial layer on a substrate by exposing at least a portion of a surface of said substrate to a beam of molecules or atoms in a vacuum chamber, said beam of molecules or atoms being produced by evaporation from a source, said method being CHARACTERISED IN THAT , during evaporation from said source, at least a portion of a surface of said apparatus interior to said vacuum chamber comprises adherence means for said molecules or atoms, the material of said adherence means being chosen to permit epitaxial deposition of said atoms or molecules on said adherence means, whereby flaking-off from said surface interior to said vacuum chamber is reduced.

9. The method of claim 8, CHARACTERISED IN THAT the material of said epitaxial layer is selected from the group consisting of silicon, germanium, cobalt, nickel, silicon-germanium alloys, compounds comprising silicon, and compounds comprising germanium.

FIG. 1

FIG. 2

0 276 914